# EUROPEAN PATENT APPLICATION

(11) **EP 2 474 647 A1**
(43) Date of publication of application: **11.07.2012**
(21) Application number: 11150237.3
(22) Date of filing: 05.01.2011
(51) Int. Cl.: C23C 28/00, C23C 30/00

(54) **Coating barrier layer and manufacturing process**

(71) Applicant: Asociacion de la Industria Navarra (AIN), 31191 Cordovilla (Navarra ) (ES); Gencoa Limited, Liverpool L24 9HP (GB)
(72) Inventor: Bellido-González, Victor, Liverpool L24 9HP (GB); García Fuentes, Gonzalo, 31191 Cordovilla (Navarra) (ES); García Lorente, José Antonio, 31191 Cordovilla (Navarra) (ES); Rodríguez Trías, Rafael, 31191 Cordovilla (Navarra) (ES)
(74) Representative: Cabinet Plasseraud

(57) **Abstract**

Coating barrier layer and manufacturing process, for coating a base substrate (1), comprising said barrier layer a group of, at least, an inorganic layer (2a) and a polymeric layer (3), where a metal rich interface layer (2ay) is disposed between the inorganic layer (2a) and the polymeric layer (3).

## Description

### Field of the art

This invention relates to the deposition of layers in vacuum coating technology applied to barrier applications. This invention also relates to the use of such barriers in product and devices.

### State of the art

Vacuum barrier coating technology has been mainly applied to packaging industry for many decades. It involves the deposition of a layer, generally of inorganic nature, that would add barrier properties, generally to air and H2O vapour, to the packaging material, generally of organic nature such as PET (Polyethylene terephthalate) polymeric layer. The quality of the barrier depends on the intrinsic properties of the substrate and layers and the defects of the deposited layers. By the nature of the vacuum deposition the critical part is the defect level of the deposited layer, typically of inorganic nature.

In recent years a multilayer polymeric - inorganic multilayer has become the best performer in barrier properties as the polymeric layer is used to block the defects of the inorganic layer, while the inorganic layer offers high barrier properties. There are two main groups of inorganic layers: pure metal, like the Aluminium coating and inorganic compounds, mainly transparent oxides, like AlOx. [FRAUNHOFER GES FORSCHUNG [DE]; DE10255822, W02004050945 (A3), US7541070 (B2)]. The metallic coating layers have advantages but in many applications such as in certain food packaging and transparent display technology the transparency is a need that cannot be met by this type of layers. The inorganic compound layer, mainly oxides, have the advantage of the barrier properties but the disadvantage of chemical interface with the polymeric layer and the propensity to a large level of defects.

Under working conditions it is also fundamental to have a good adhesion between layers and a suitable interface bonding. The above inventions rely on processes where there is certain interface chemistry mainly based on the use of Aluminium or Titanium metals as oxides.

The present invention improves the interlayer bonding properties and therefore the barrier properties of the resulting device.

### Object of the invention

According to the present invention an architecture of barrier layer construction is provided with enhanced interlayer chemistry between a polymeric layer and a inorganic layer by changes in the chemical composition of the interface of a substantially inorganic compound layer and a substantially organic polymeric layer.

In one of the layer constructions of the present invention the interface between the inorganic compound layer, like AlOx, is made of a substantially metal rich interface with thickness below 50 nm, where the metal rich would tend to form atomic clusters which would tend to plug the layer defects and high surface energy points enabling a strong chemical bond with the polymeric layer. The metal rich deposition could be achieved by a change in the chemical ratio between metal and a reactive gas, such as 02, which could be part of the main inorganic barrier layer. For example from a high transparency AlOx inorganic layer where the ration Al:O is around 0.6-0.7 to a metal rich interface layer where the Al:O ratio could be higher than 1.5. In general the metal rich interface would have a metal atomic content more than double than the in the inorganic compound layer, generally of transparent nature. The rich metal interface layer could also include metal elements of different nature such as silver "Ag" , copper "Cu", gold "Au", tin "Sn", zinc "Zn", titanium "Ti", zirconium "Zr", yttrium "Y", aluminium "Al", magnesium "Mg", indium "In" which have enhanced cluster formation ability. The nature of the process favours the transparency of the barrier layer construction.

Generally the deposition process would involve the deposition from a metal based material in a vacuum plasma environment with a reactive gas. Generally the metal would be placed in a vapour phase by methods such as PVD "Physical Vapour Deposition" (thermal evaporation, sublimation, sputtering, arc) but also PACVD "Plasma Assisted Chemical Vapor Deposition" (e.g. from metalorganic and inorganic coordination compounds of suitable vapour pressure). Generally the metal reacting element would come from a gas, commonly but not exclusively 02, or vapours, such as H2O, or mixtures. Generally the inorganic layer deposition, followed by the rich metal interface layer would be followed by a process of polymer deposition. The polymer deposition could be performed for example by injecting, printing, nebulazing a monomer mixture with a subsequent polymerization process such as electron beam, ion beam, UV, flash-UV, plasmapolymerization, or any other process.

In another part of the present invention a desirable element namely magnesium "Mg" and, or, yttrium "Y" would be part of the composition of the inorganic layer, for example Al-Mg based alloys, or Y-doped Al alloys, or Al-Mg:Y, Al-Si:Y alloys. In these cases the Mg has an enhanced role in interface chemistry with the polymeric layer and the Y element has an enhanced role in defect coverage therefore enhancing the effectiveness of the barrier layer.

The barrier layer construction could start with polymerization followed by metal rich interface layer and inorganic compound layer or could start with inorganic layer followed by metal rich interface layer and then polymer layer. Generally an inorganic layer would be deposited over the polymeric layer, preceded by a metal rich interface layer.

As another part of the present invention any number of layers could be alternatively deposited creating a multilayer construction.

The present invention also relates to any type of substrate that could be processed with this barrier layer structure.

The present invention also relates to a barrier layer construction in a batch, inline, web or a series of separate processes deriving in this barrier construction.

### Description of the figures

The invention will be further described by way of example only with reference to the following figures in which:
Figure 1 shows a cross section of one of the current state of the art barrier layer construction.
Figure 2 shows another cross section of the current state of the art enhanced barrier layer.
Figure 3 and 4 shows a cross section of the barrier layer according to the present invention, in which a rich metal interface layer is disposed between an inorganic layer and a polymeric layer.
Figures 5 to 7 shows other examples of barrier layer constructions according to the present invention with multiple rich metal interface layers disposed between multiple inorganic layers and multiple polymeric layers.

### Detailed description of the invention

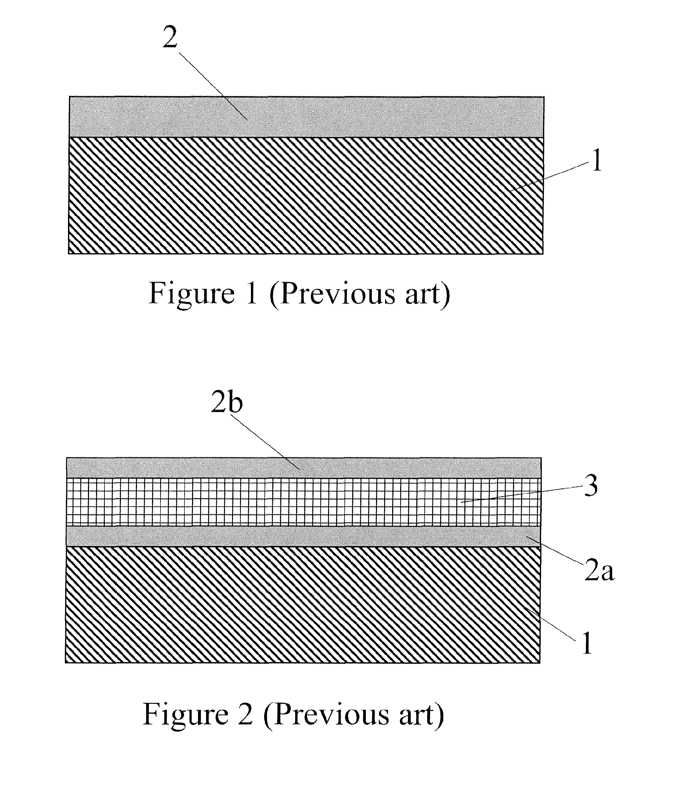

Figure 1 shows a cross section of one of the current state of the art barrier layer construction. The base substrate (1), typically a polymeric layer such as PET, is coated with an inorganic layer (2) such as Al or AlOx.
Figure 2 shows another cross section of the current state of the art enhanced barrier layer in which a polymer deposited layer (3) is sandwiched between two inorganic layers (2a,2b).

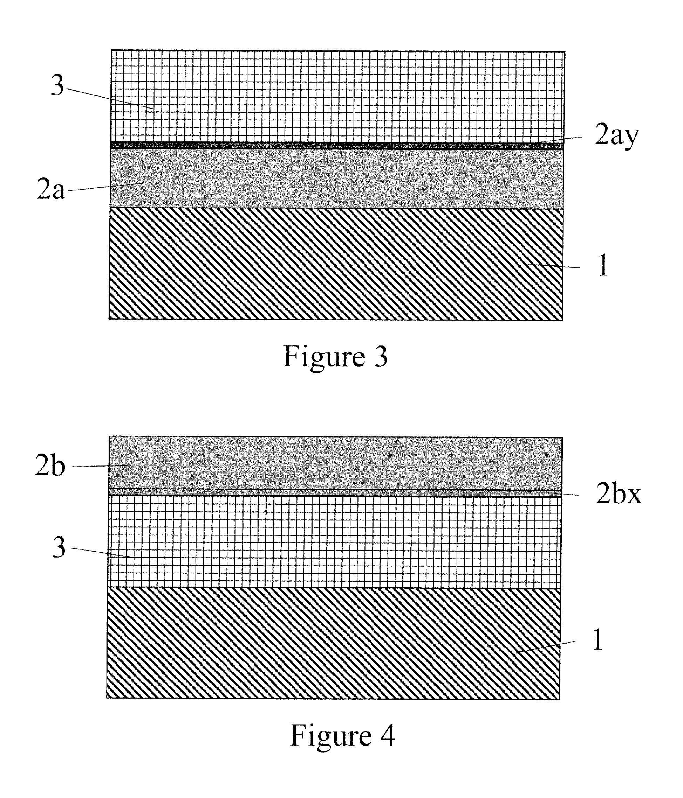

Figure 3 shows a cross section of the present invention barrier layer construction where the base substrate (1) is coated with an inorganic layer (2a) followed by a metal rich interface layer (2ay) which enhanced the bonding and coverage of a polymer deposited layer (3).
Figure 4 shows another cross section of a barrier layer according to the present invention. The barrier layer construction in this example starts by covering the base substrate (1) with a polymeric layer (3) and after that a metal rich interface layer (2bx) is deposited in order to condition the polymeric layer (3) for a good interface bonding and coverage for the inorganic layer (2b).

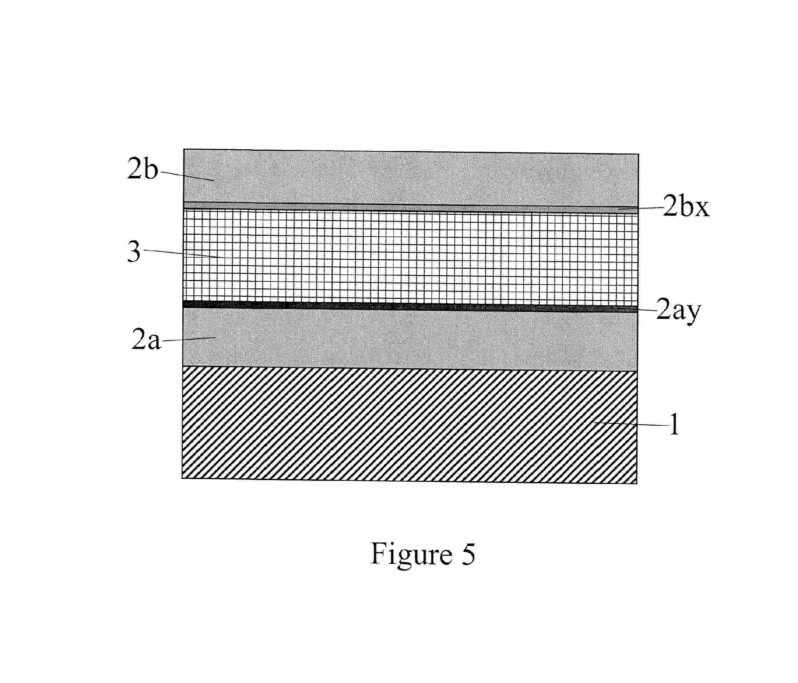

Figure 5 shows another cross section of a barrier layer according to another example of the present invention. As in Figure 3, the base substrate (1) is coated with an inorganic layer (2a) followed by a metal rich interface layer (2ay) which enhanced the bonding and coverage of the polymer deposited layer (3). And after that a metal rich interface layer (2bx) is deposited in order to condition the polymeric layer (3) for a good interface bonding and coverage for the top inorganic layer (2b).

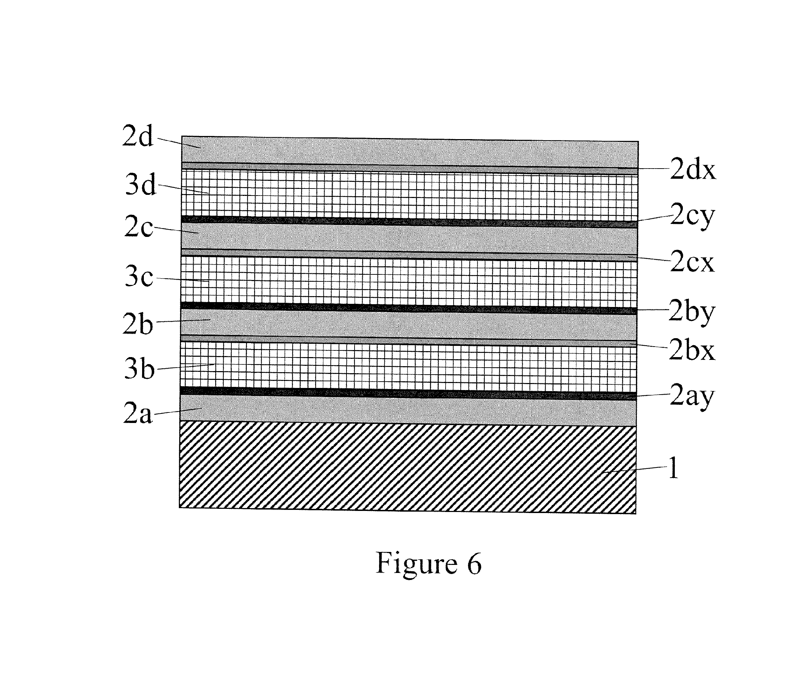

Figure 6 shows a cross section of another barrier layer construction of the present invention where the multilayer barrier construction over the base substrate (1) is formed by a series of inorganic layers (2a, 2b, 2c, 2d) that are alternated by polymeric layers (3b, 3c, 3d), with suitable metal-rich interfaces layers (2ay, 2by, 2cy and 2bx, 2cx, 2dx).

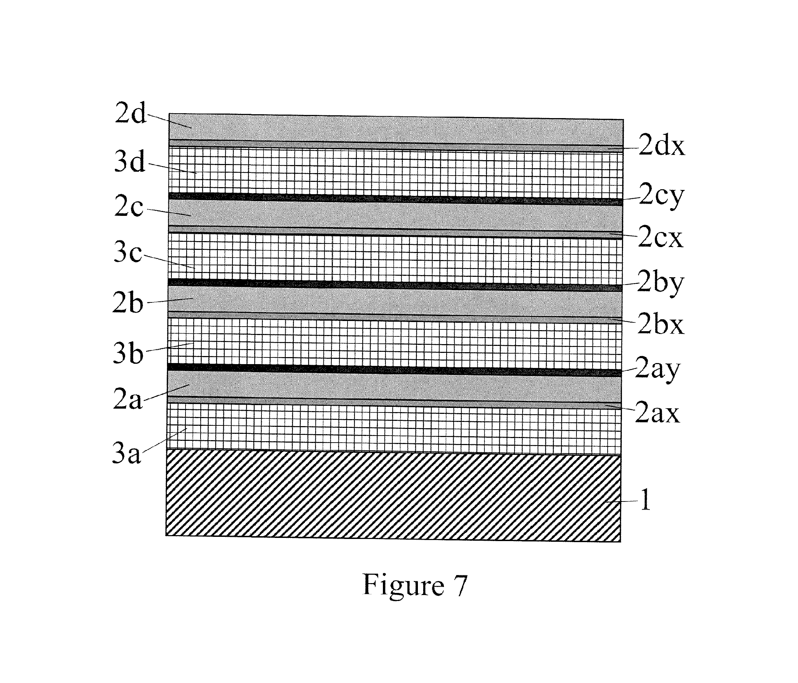

Figure 7 shows a cross section of another barrier layer construction of the present invention where the multilayer barrier construction over the base substrate (1) starts with a polymeric layer (3a) and a metal-rich interface layer (2ax). Then the series of inorganic layers (2a, 2b, 2c, 2d) are alternated by polymeric layers (3b, 3c, 3d), with suitable metal rich interfaces layers (2ay, 2by, 2cy and 2bx, 2cx, 2dx).

## Claims

1. Coating barrier layer, for coating a base substrate (1), comprising said barrier layer a group of ,at least, an inorganic layer (2a,2b,2c,2d) and a polymeric layer (3,3a,3b,3c,3d), **characterized in that** a metal rich interface layer (2ay,2bx,2cx,2dx,2ay,2by,2cy,) is disposed between the inorganic layer (2a,2b,2c,2d ) and the polymeric layer (3, 3a, 3b, 3c, 3d) .

2. Coating barrier layer, according to claim 1, **characterized in that** the metal rich interface layer (2ay,2bx,2cx,2dx,2ay,2by,2cy,) presents a thickness below 50 nm.

3. Coating barrier layer, according to claim 1, **characterized in that** the rich metal interface layer (3,3a,3b,3c,3d) include different metal elements such as silver, copper, gold, tin, zinc, titanium, zirconium, yttrium, aluminium, magnesium, or indium.

4. Coating barrier layer, according to claim 1, **characterized in that** the rich metal interface layer (3,3a,3b,3c,3d) is disposed upper the inorganic layer (2a,2b,2c,2d) and below the polymeric layer (3,3a,3b,3c,3d).

5. Coating barrier layer, according to claim 1, **characterized in that** the rich metal interface layer (3,3a,3b,3c,3d) is disposed upper the polymeric layer (3,3a,3b,3c,3d) and below the inorganic layer (2a,2b,2c,2d).

6. Coating barrier layer, according to claim 1, **characterized in that** the rich metal interface layer (3,3a,3b,3c,3d) have, at least, a metal atomic content more than double than the inorganic layer (2a,2b,2c,2d).

7. Coating barrier layer, according to claim 1, **characterized in that** comprises multiple inorganic layers alternated with multiple polymeric layers, where suitable metal rich interface layers are disposed between said inorganic layers and said polymeric layers.

8. Coating barrier layer, according to claim 1, **characterized in that** the polymeric layer (3,3a,3b,3c,3d) is a layer made of monomers, oligomers or polymers or a mixture of them applied by injection, printing or nebulization.

9. Coating barrier layer, according to claim 8, **characterized in that** the polymeric layer (3,3a,3b,3c,3d) is a layer made of monomers, oligomers or polymers or a mixture of them dried, cured or polymerized.

10. Process for manufacturing the coating barrier layer of the previous claims, **characterized in that** the manufacturing process of the coating barrier layer is made by a vacuum of subatmospheric pressures and is performed in a batch, inline or web process system.
